# EUROPÄISCHE PATENTANMELDUNG

(11) **EP 4 155 742 A1**
(43) Veröffentlichungstag der Anmeldung: **29.03.2023**
(21) Anmeldenummer: 21199116.1
(22) Anmeldetag: 27.09.2021
(51) Int. Cl.: G01R 31/309, G01R 31/28

(54) **LEISTUNGSMODUL**

(71) Anmelder: Siemens Aktiengesellschaft, 80333 München (DE)
(72) Erfinder: Kriegel, Kai, 81739 München (DE); Mitic, Gerhard, 81827 München (DE)
(74) Vertreter: Siemens Patent Attorneys

(57) **Zusammenfassung**

Die vorliegende Erfindung betrifft ein Leistungsmodul (2) sowie ein Verfahren zur Bestimmung einer Alterung eines Leistungsmoduls (2). Das Leistungsmodul (2) weist auf:
- mindestens einen Halbleiterchip (12),
- einen Gehäusedeckel (10) mit einer von dem Halbleiterchip (12) abgewandten Oberseite (10.1) und einer dem Halbleiterchip (12) zugewandten Unterseite (10.2),
- eine IR-transparente Vergussmasse (22), welche in einem Hohlraum zwischen dem mindestens einen Halbleiterchip (12) und dem Gehäusedeckel (10) angeordnet ist, und
- mindestens einen Sensor (4) zur Messung von IR-Strahlung, die von mindestens einem Halbleiterchip (12) emittiert wird, wobei der mindestens eine Sensor (4) über dem Halbleiterchip (12) an der Unterseite (10.2) des Gehäusedeckels (10) und/oder in der Vergussmasse (22) angeordnet ist.

## Beschreibung

Die vorliegende Erfindung betrifft ein Leistungsmodul sowie ein Verfahren.

Leistungsmodule (engl.: Power Modules), z. B. IGBT-Module und SiC-MOS, in leistungselektronischen Umrichtern unterliegen aufgrund ihrer thermischen Belastung während des Betriebs einer merklichen Alterung (IGBT = Insulated-Gate Bipolar Transistor; SiC = Siliziumcarbid; MOS = Metal Oxide Semiconductor). Diese Alterung wird hauptsächlich durch eine hohe Zahl von Lastzyklen der Betriebserwärmung und -abkühlung hervorgerufen, die zur allmählichen Zerstörung von Chiplotschichten unter den Halbleiterchips und zur Ermüdung von Bonddrähten und Chipmetallisierungen führen, die den Strom in die schaltenden und gleichrichtenden Chips leiten. Typische Alterungserscheinungen sind der Bond Lift-Off (Abheben und Riss des Bonddrahtes), der Heel-Crack und die Lotermüdung von Chip- und Systemlot (unterliegendes Lot des Keramikträgers). Ein Problem im Zusammenhang mit der Alterung ist, dass der Zeitpunkt eines Ausfalles eines Leistungsmoduls so stark und in so komplizierter Weise von den vergangenen Belastungen abhängt, dass auch fortgeschrittene Vorhersagemodelle sehr ungenau sind.

In schwer zugänglichen oder dauerbetriebenen Einsatzgebieten, in denen ein Ausfall eines Leistungsmoduls in einem Umrichter unbedingt vermieden werden muss, z. B. in einer Off-Shore-Windkraftanlage oder einer Traktionsanwendung, gibt es heute verschiedene Lösungswege, einen überraschenden Ausfall zu vermeiden. So kann durch Redundanz der Leistungselektronik oder durch Maßnahmen auf der Wartungsebene, etwa durch einen präventiven Austausch der Leistungsmodule, spontanen Stillständen begegnet werden. Beide Lösungen verursachen einen erhöhten Verbrauch an Ressourcen und sind teuer.

Mit Hilfe von fortgeschrittenen thermischen Modellen auf Basis von vorherigen, beschleunigten Lebensdauerprüfungen kann auf die bereits verbrauchte Lebensdauer und die Restlebensdauer eines Leistungsmoduls geschlossen werden. Aufgrund der hohen Komplexität der Abhängigkeiten sind diese Berechnungen jedoch mit sehr großen Fehlern behaftet. Numerische Methoden der Lebensdauerberechnung können die Belastungen im Feld daher nur beschränkt rekonstruieren.

Von einigen Leistungsmodulherstellern werden IGBT-Leistungsschaltmodule angeboten, in denen kleine Messdioden als Temperatursensor integriert sind. Über das ansteigende Temperaturniveau des IGBT bei einem gegebenem Betriebsstrom lässt sich dann indirekt auf eine (Lot-) Alterung schließen. Dioden im Leistungsmodul zur Temperaturerfassung benötigen Fläche, die sonst für eine aktive Chipfläche genutzt werden könnte. Diese Lösung ist daher teuer.

Eine Messung von temperaturempfindlichen elektrischen Parametern des Leistungsmoduls ist messtechnisch sehr aufwändig und mit hohen Fehlern behaftet, da diese Parameter vom Betriebszustand, d. h. Spannung und Strom, des Leistungsmoduls abhängen. Zudem benötigt eine solche Messung eine aufwändige Temperaturkalibrierung, welche zusätzliche Ungenauigkeiten verursacht.

Es ist also eine Aufgabe, eine zuverlässige Alterungsbestimmung von Leistungsmodulen von Umrichtern bereitzustellen, die eine Prognose für die noch verbleibende Betriebslebensdauer zulässt.

Diese Aufgabe wird erfindungsgemäß durch ein Leistungsmodul mit den in Anspruch 1 angegebenen Merkmalen gelöst. Diese Aufgabe wird erfindungsgemäß durch ein Verfahren mit den in Anspruch 7 angegebenen Merkmalen gelöst.

Das erfindungsgemäße Leistungsmodul weist mindestens einen Halbleiterchip, z. B. einen IGBT-Chip auf. Das erfindungsgemäße Leistungsmodul weist einen Gehäusedeckel mit einer von dem Halbleiterchip abgewandten Oberseite und einer dem Halbleiterchip zugewandten Unterseite auf. Das erfindungsgemäße Leistungsmodul weist eine IR-transparente Vergussmasse auf, welche in einem Hohlraum zwischen dem mindestens einen Halbleiterchip und dem Gehäusedeckel angeordnet ist (IR = Infrarot). Als Vergussmasse können beispielsweise Silikongele verwendet werden, z. B. Dow Corning 527, Shin Etsu 1041, Wacker Silgel 612. Und das erfindungsgemäße Leistungsmodul weist mindestens einen Sensor zur Messung von IR-Strahlung, die von mindestens einem Halbleiterchip emittiert wird, auf. Dabei ist der mindestens eine Sensor über dem Halbleiterchip an der Unterseite des Gehäusedeckels und/oder in der Vergussmasse angeordnet.

Das erfindungsgemäße Verfahren zur Bestimmung einer Alterung eines Leistungsmoduls, wobei das Leistungsmodul mindestens einen Halbleiterchip, einen Gehäusedeckel mit einer von dem Halbleiterchip abgewandten Oberseite und einer dem Halbleiterchip zugewandten Unterseite, und eine IR-transparente Vergussmasse, welche in einem Hohlraum zwischen dem mindestens einen Halbleiterchip und dem Gehäusedeckel angeordnet ist, aufweist. Dabei umfasst das Verfahren folgende Schritte: - Anordnen von mindestens einem Sensor zur Messung von IR-Strahlung, die von mindestens einem Halbleiterchip emittiert wird, über dem Halbleiterchip an der Unterseite des Gehäusedeckels und/oder in der Vergussmasse; - Messen, durch den Sensor, von IR-Strahlung, die von mindestens einem Halbleiterchip emittiert wird; - Senden, durch den Sensor, von aus der Messung gewonnenen Messwerten auf einem Übertragungspfad zu einer Steuereinheit; - Analysieren, durch die Steuereinheit, der Messwerte und Bestimmen einer Alterung des Leistungsmoduls auf Basis der Messwerte.

Erfindungsgemäß wird die IR-Abstrahlung von Halbleiterchips genutzt, um die Alterung leistungselektronischer Bauteile zu bestimmen.

Der Erfindung liegt die Erkenntnis zugrunde, dass eine gemessene Temperatur des Leistungsmoduls als ein Maß für eine Alterung des Leistungsmoduls herangezogen werden kann.

Es ist bekannt, dass elektrische Bauteile aufgrund der Ermüdung der Verbindungstechnologien altern. Dies geht einher mit einer erhöhten Temperatur der elektrischen Bauteile. Diese erhöhte Temperatur kommt durch Delaminationen im thermischen Pfad zustande oder resultiert aus erhöhten elektrischen Verlusten durch erhöhte elektrische Widerstände aufgrund erhöhter elektrischer Übergangswiderstände durch Delaminationen. Bei ansonsten gleichbleibenden elektrischen Betriebsbedingungen, d. h. Strom und Spannung, einer leistungselektronischen Schaltung resultieren daraus erhöhte lokale Temperaturen der leistungselektronischen Bauteile.

Erfindungsgemäß sollen gemessene Temperaturen bei identischen aufeinanderfolgenden Schaltzyklen und Strömen als ein Maß für eine Alterung des Leistungsmoduls herangezogen werden. Der Gatetreiber und die übergeordnete Steuerung können zur Steuerung und elektronischen Erfassung der Temperaturmessung genutzt werden.

Unabhängig vom Betriebszustand kann aber auch die gemessene Temperatur als Maßstab für eine Alterung des Leistungsmoduls herangezogen werden. Resultieren im Betrieb mehrfach Temperaturen, die den maximal spezifizierte Bauteiltemperaturen entsprechen oder diese überschreiten, so ist von einer erheblichen Alterung auszugehen und ein Austausch des Leistungsteils ist erforderlich. Alternativ kann als Ausfallkriterium der prozentuale Anstieg der Temperatur bei identischen Betriebsbedingungen gewählt werden. Eine thermomechanische Alterung ist bei einem Anstieg von mindestens 5% bis maximal 20% erfolgt.

Die IR-Sensoren sollen als Detektoren in einem Leistungsmodul oberhalb eines ausgewählten Leistungshalbleiters angeordnet werden. Der Silikonverguss auf den Halbleitern ist für die zu messende IR-Strahlung transparent. Die Sensoren können daher im Hartverguss oder im Gehäusedeckel des Leistungsmoduls angebracht werden und die Temperaturen durch eine externe Messelektronik erfasst und ausgewertet werden.

Eine Messung mit IR-Detektoren ist elektrisch (galvanisch) vom Leistungsmodul getrennt und nicht störanfällig. Eine Messauflösung im Millisekundenbereich ist technisch einfach zu realisieren und kostengünstig. Die IR-Detektoren müssen nicht im Schaltungsträger integriert werden, sondern können im Packaging oberhalb der Leistungsbauelemente untergebracht werden. Durch die hohe zeitliche Auflösung können ggf. auch die Lage der Delamination bestimmt werden.

Der Ursprung der von den Halbleiterchips emittierten IR-Strahlung kann sowohl die thermische Strahlung der Halbleiterchips als auch die Photolumineszenz der Halbleiterchips sein. Bei der Photolumineszenz wird die strahlende Rekombination von Elektronen-Loch-Paaren zur Temperaturmessung genutzt. Bei der strahlenden Rekombination rekombinieren Elektronen-Lochpaare kontinuierlich während des elektrischen Betriebs, ohne dass eine aktive Anregung, z. B. durch eine Bestrahlung des Halbleiters mit kurzwelliger Strahlung, erfolgen muss. Ein gewisser Prozentsatz erfolgt strahlend (Photonen), der größte Anteil erfolgt durch einen Wärmeübertrag an Phononen. Der Wellenlängenbereich, in dem die durch die Photolumineszenz erzeugte IR-Strahlung liegt, hängt vom Halbleiter ab. Die Photolumineszenz von Silizium liegt im Wellenlängenbereich zwischen 1000 nm und 1200 nm, wobei sich das Emissionsmaximum bei 300K bei einer Wellenlänge von 1130 nm befindet. Diese Wellenlänge entspricht ungefähr der Bandlückenenergie von Silizium. Der Vorgang der strahlenden Rekombination ist temperaturabhängig und erlaubt daher einen Rückschluss auf die Temperatur des Halbleiters. Die Rekombinationsstrahlung lässt sich mit passenden Photodioden im Bereich der zu messenden Chips detektieren und erlaubt einen Rückschluss auf die Bauteiltemperatur im Betrieb. Das Messprinzip und der Nachweis der Alterung ist analog zur Detektion mittels Wärmestrahlung.

Produkte, in denen die Erfindung verwendet werden kann, sind z. B. Leistungsmodule in elektrischen Umrichtern für Traktionsanwendungen, Elektroautos oder Windkraftanlagen.

Vorteilhafte Ausgestaltungen und Weiterbildungen der Erfindung sind in den abhängigen Ansprüchen angegeben.

Gemäß einer vorteilhaften Ausgestaltung der Erfindung wird der Sensor über dem wärmsten Halbleiterchips angeordnet. Im Multichipmodul werden meist zahlreiche IGBT-Chips zu einer bestimmten Schaltungstopologie verbaut. Zur Lebensdauervorhersage ist es sinnvoll, einen der lokal wärmsten Chips auszuwählen, da dieser am schnellsten altern wird. Die Lage des wärmsten Chips wird im Allgemeinen durch die thermische Verkopplung zu benachbarten Chips bestimmt oder kann mittels einmaliger IR-Messung oder vorausgehende Simulationen ermittelt werden.

Gemäß einer vorteilhaften Ausgestaltung der Erfindung werden Sensoren über dem wärmsten Halbleiterchip und über dem kühlsten Halbleiterchip, z. B. IGBT-Chips, angebracht. Ein zeitlicher Vergleich der Temperaturdifferenz erlaubt gleichermaßen einen Rückschluss auf die Alterung, da der wärmere Chip ungleich schneller im Vergleich zum kühleren Chip altert. Als Ausfallkriterium kann der prozentuale Anstieg der Temperaturdifferenz bei identischen Betriebsbedingungen gewählt werden. Eine thermomechanische Alterung ist bei einem Anstieg von mindestens 5% bis maximal 20% erfolgt.

Gemäß einer vorteilhaften Ausgestaltung der Erfindung kann der Sensor die IR-Strahlung mit einer Zeitauflösung von etwa 0,1 ms bis 0,1 s, vorzugsweise von etwa 1 ms, messen. Der Vorteil dabei ist, dass die Photodetektoren auf diese Weise den thermischen Veränderungen des Leistungsmoduls zeitlich folgen können. In den jeweiligen Schaltvorgängen lassen sich dadurch die maximalen Temperaturen des Bauteils erfassen. Die lokalen Bauteiltemperaturen hängen im Allgemeinen von den thermischen Verlustleistungen in den vorhergehenden Sekunden bis Minuten ab. Die Verlustleistungen wiederum hängen von den Strömen und Schaltvorgängen ab. Gemessene Temperaturen erlauben daher nur bei identischen Schaltzyklen und Strömen einen Rückschluss auf die thermomechanische Alterung. Der Gatetreiber und die Steuerung können dazu passende Schaltvorgänge identifizieren oder bewusst einleiten, um definierte und vergleichbare Temperaturen zu erfassen.

Gemäß einer vorteilhaften Ausgestaltung der Erfindung ist der Sensor ein IR-Sensor, ein Photodetektor oder eine PIN-Diode. Erfindungsgemäß sollen im Leistungsmodul IR-Sensoren bzw. Photodetektoren, PIN-Dioden eingebaut werden, welche die thermische Abstrahlung der Leistungsbauteile detektieren (PIN = Positive Intrinsic Negative).

Im Folgenden wird die Erfindung anhand eines Ausführungsbeispiels unter Zuhilfenahme der beiliegenden Zeichnung erläutert. Es zeigt jeweils schematisch und nicht maßstabsgetreu
- Fig. 1: einen Schnitt eines Leistungsmoduls; und
- Fig. 2: eine Draufsicht des Leistungsmoduls von Fig. 1; und
- Fig. 3: eine weitere Ausgestaltung eines erfindungsgemäßen Leistungsmoduls.

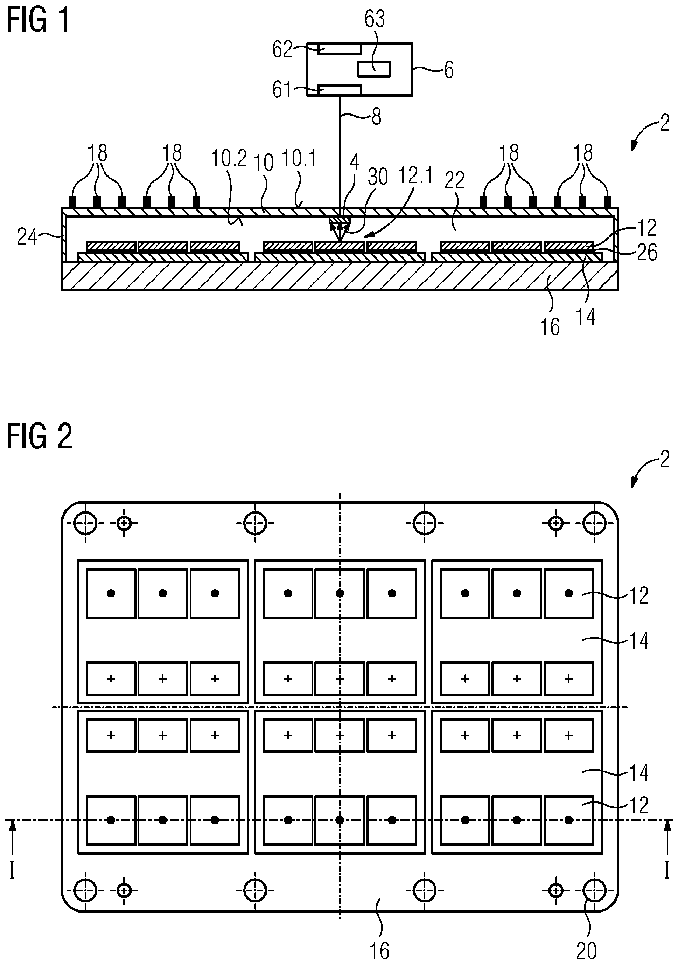

Fig. 1 zeigt einen Schnitt I-I eines Leistungsmoduls 2. Auf einer quaderförmigen Bodenplatte 16, welche entlang seiner beiden Längsseiten jeweils Durchgangslöcher 20 zur Befestigung der Bodenplatte 16 aufweist, sind mehrere Substrate 14 angeordnet. Auf den Substraten 14 sind mithilfe von Chiplotschichten 26 jeweils mehrere Halbleiterchips 12 fixiert. Die Substrate 14 und die Halbleiterchips 12 sind in einem Gehäuse, welches durch die Bodenplatte 16, auf der Bodenplatte 16 aufsitzende Seitenwände 24 und einen auf den Seitenwänden 24 aufliegenden Gehäusedeckel 10 gebildet ist, allseitig umschlossen und eingehaust, wobei der Hohlraum im Inneren des Gehäuses mit einem Verguss 22 aus Silikonmasse ausgefüllt ist. Aus der von den Halbleiterchips 12 abgewandten Oberseite 10.1 des Gehäusedeckels 10 ragen elektrische Anschlüsse 18 zum Verbinden des Leistungsmoduls 2 mit elektrischen Leitungen vertikal nach oben.

Fig. 2 zeigt eine Draufsicht des Leistungsmoduls 2 ohne Seitenwände 24, Gehäusedeckel 10 und Verguss 22. Dabei sind die Halbleiterchips 12 zu erkennen, die die Halbleiterchips 12 tragenden Substrate 14 sowie die die Substrate 14 tragende Bodenplatte 16.

An der den Halbleiterchips 12 zugewandten Unterseite 10.2 des Gehäusedeckels 10 ist ein Sensor 4 angeordnet, der IR-Strahlung 30 von den Halbleiterchips 12 empfangen kann, weil die Silikonmasse, aus der der Verguss 22 besteht, für IR-Strahlung 30 transparent ist. Der Sensor 4 ist durch einen Übertragungspfad 8 mit einer Steuereinheit 6 verbunden. Der Übertragungspfad 8 dient einer drahtlosen Übertragung, z. B. per Funk, WLAN oder Induktion, oder drahtgebundene Übertragung, z. B. über ein Strom- und/oder Signal-Kabel, von Daten. Auf dem Übertragungspfad 8 können vom Sensor 4 erfasste Messwerte vom Sensor 4 zu der Steuereinheit 6 übertragen werden. Es ist auch möglich, dass elektrische Energie, welche der Sensor 4 zu seinem Betrieb benötigt, von der Steuereinheit 6 zu dem Sensor 4 übertragen wird.

Die Steuereinheit 6 empfängt die Messwerte über eine Eingabeschnittstelle 61, analysiert sie mithilfe eines Prozessors 63 und stellt die Analyseergebnisse des Prozessors 63 über eine Ausgabeschnittstelle 62 zur Verfügung. So können die Analyseergebnisse beispielsweise von der Ausgabeschnittstelle 62 zu einem PC oder einem Smartphone übertragen werden und an einer Ausgabevorrichtung, z. B. einem Monitor oder einem Display, ausgegeben werden, wo sie von einem Betreiber des Leistungsmoduls gelesen werden können. Der Betreiber ist somit in der Lage, rechtzeitig entsprechende Maßnahmen ergreifen.

Wärmestrahlung, die von den Halbleiterchips 12 während ihres Betriebs emittiert wird, gelangt durch den Verguss 22 zu dem Sensor 4. Dabei ist der Sensor 4 oberhalb desjenigen Halbleiterchips 12.1 angeordnet, der während des Betriebs die höchste Temperatur der Halbleiterchips 12 aufweist, da dieser am schnellsten altern wird. Der Sensor 4 misst IR-Strahlung aus einem definierten Spektralbereich mit einer vorgegebenen zeitlichen Auflösung, z. B. 1 ms, und sendet die Messwerte auf dem Übertragungspfad 8 zu der Steuereinheit 6. Die Steuereinheit 6 empfängt und analysiert die Messwerte.

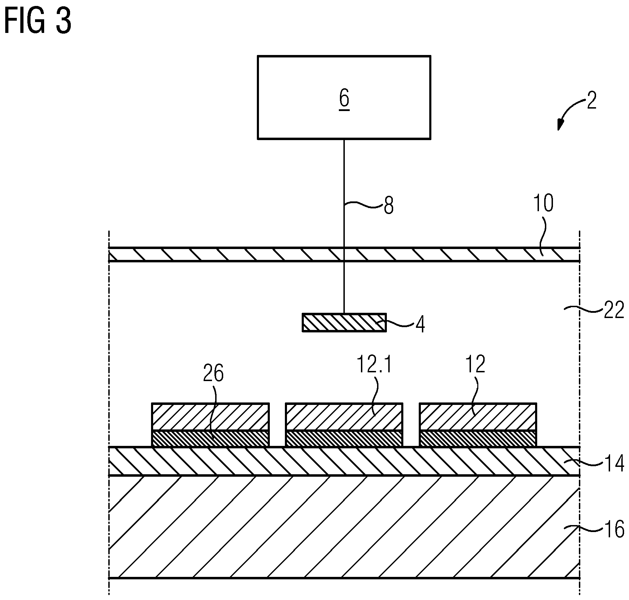

Fig. 3 zeigt einen Schnitt eines Leistungsmoduls 2 gemäß einer weiteren Ausgestaltung, bei der der Sensor 4 nicht am Gehäusedeckel 10 des Gehäuses fixiert, sondern in die Vergussmasse 22 eingebettet ist. Ansonsten wird auf die Beschreibung zu den Fig. 1 und 2 verwiesen.

## Patentansprüche

1. Leistungsmodul (2), aufweisend
- mindestens einen Halbleiterchip (12),
- einen Gehäusedeckel (10) mit einer von dem Halbleiterchip (12) abgewandten Oberseite (10.1) und einer dem Halbleiterchip (12) zugewandten Unterseite (10.2),
- eine IR-transparente Vergussmasse (22), welche in einem Hohlraum zwischen dem mindestens einen Halbleiterchip (12) und dem Gehäusedeckel (10) angeordnet ist, und
- mindestens einen Sensor (4) zur Messung von IR-Strahlung, die von mindestens einem Halbleiterchip (12) emittiert wird, wobei der mindestens eine Sensor (4) über dem Halbleiterchip (12) an der Unterseite (10.2) des Gehäusedeckels (10) und/oder in der Vergussmasse (22) angeordnet ist.

2. Leistungsmodul (2) nach Anspruch 1,
wobei der Sensor (4) über dem wärmsten Halbleiterchip (12) angeordnet ist.

3. Leistungsmodul (2) nach einem der Ansprüche 1 oder 2,
wobei mindestens ein Sensor (4) über dem wärmsten Halbleiterchip (12) und mindestens ein Sensor (4) über dem kühlsten Halbleiterchip (12) angeordnet ist.

4. Leistungsmodul (2) nach einem der vorhergehenden Ansprüche,
wobei der Sensor (4) die IR-Strahlung mit einer Zeitauflösung von etwa 0,1 ms bis 0,1 s, vorzugsweise bei etwa 1 ms, messen kann.

5. Leistungsmodul (2) nach einem der vorhergehenden Ansprüche,
wobei der Sensor (4) ein IR-Sensor, ein Photodetektor oder eine PIN-Diode ist.

6. Vorrichtung umfassend ein Leistungsmodul (2) nach einem der vorhergehenden Ansprüche, eine Steuereinheit (6) zur Analyse von Messwerten und einen Übertragungspfad (8) zur Übertragung von Messwerten, die vom Sensor (4) gemessen wurden, vom Sensor (4) zu der Steuereinheit (6).

7. Verfahren zur Bestimmung einer Alterung eines Leistungsmoduls (2), wobei das Leistungsmodul (2) mindestens einen Halbleiterchip (12), einen Gehäusedeckel (10) mit einer von dem Halbleiterchip (12) abgewandten Oberseite (10.1) und einer dem Halbleiterchip (12) zugewandten Unterseite (10.2), und eine IR-transparente Vergussmasse (22), welche in einem Hohlraum zwischen dem mindestens einen Halbleiterchip (12) und dem Gehäusedeckel (10) angeordnet ist, aufweist,
wobei das Verfahren folgende Schritte umfasst:
- Anordnen von mindestens einem Sensor (12) zur Messung von IR-Strahlung, die von mindestens einem Halbleiterchip (12) emittiert wird, über dem Halbleiterchip (12) an der Unterseite (10.2) des Gehäusedeckels (10) und/oder in der Vergussmasse (22);
- Messen, durch den Sensor (4), von IR-Strahlung, die von mindestens einem Halbleiterchip (12) emittiert wird;
- Senden, durch den Sensor (4), von aus der Messung gewonnenen Messwerten auf einem Übertragungspfad (8) zu einer Steuereinheit (6) ;
- Analysieren, durch die Steuereinheit (6), der Messwerte und Bestimmen einer Alterung des Leistungsmoduls (2) auf Basis der Messwerte.

8. Verfahren nach Anspruch 7,
wobei der Sensor (4) die IR-Strahlung, die von mindestens einem Halbleiterchip (12) emittiert wird, mit einer Zeitauflösung von etwa 0,1 ms bis 0,1 s, vorzugsweise bei etwa 1 ms, misst.
